# EUROPEAN PATENT APPLICATION

(11) **EP 4 779 335 A1**
(43) Date of publication of application: **22.07.2026**
(21) Application number: 25222644.4
(22) Date of filing: 11.12.2025
(51) Int. Cl.: G01R 31/382, B60L 58/12, G01R 31/3828, G01R 31/387, G01R 31/388

(54) **DISPLAY SYSTEM**

(30) Priority: 17.01.2025 JP 2025006945
(71) Applicant: Toyota Jidosha Kabushiki Kaisha, Toyota-shi, Aichi-ken 471-8571 (JP)
(72) Inventor: SUGO, Yuki, Toyota-shi, 471-8571 (JP)
(74) Representative: J A Kemp LLP

(57) **Abstract**

The ECU executes a process including a step of acquiring an estimated value of the full charge capacity, a step of acquiring a subtraction amount, a step of acquiring a SOC range that is usable, a step of subtracting the subtraction amount from the SOC range that is usable, a step of calculating a display value of the full charge capacity, and a step of displaying the display value of the full charge capacity.

## Description

### BACKGROUND OF THE INVENTION

### 1. Field of the Invention

The present disclosure relates to a display system.

### 2. Description of Related Art

For example, Japanese Unexamined Patent Application Publication No. 2003-164006 (JP 2003-164006 A) discloses a technology of calculating a degree of deterioration of a battery from a voltage value and a current value, correcting a capacity adjustment range in accordance with the calculated degree of deterioration, and displaying a current battery capacity in segments.

### SUMMARY OF THE INVENTION

In a case where a current capacity of a battery configured by a plurality of single cells is displayed as in the technology described above, when a state in which a balancing process of equalizing a state of charge (SOC) between the single cells is not executed continues, an SOC may vary between the single cells. As a result, there is a possibility that the entire capacity of the battery cannot be fully utilized, and a deviation may occur between an actual value and an estimated value of a distance travelable by electric power. Therefore, there is a possibility that the current capacity or the full charge capacity of the battery cannot be accurately displayed.

The present disclosure has been made to solve the problem described above, and an object thereof is to provide a display system that accurately displays a capacity of a battery.

A display system according to an aspect of the present disclosure is a display system that displays information related to a full charge capacity of a battery including a plurality of single cells of a lithium iron phosphate ion battery. The display system includes a display device and a control device. The control device is configured to calculate a subtraction amount using a first SOC range corresponding to a dead band that is based on an SOC set as a full charge state, and to subtract the subtraction amount from a second SOC range in which the battery is usable. The display device is configured to display the information related to the full charge capacity by using a ratio of a value obtained by subtracting the subtraction amount from the second SOC range to the second SOC range.

In this manner, by displaying the information related to the full charge capacity by using the ratio of the value obtained by subtracting the subtraction amount from the second SOC range to the second SOC range, the full charge capacity of the battery can be accurately displayed.

In an embodiment, the control device is configured to set the subtraction amount corresponding to the first SOC range when an estimated value of the full charge capacity is greater than a first value, to set a value that decreases in proportion to a decrease in the estimated value as the subtraction amount when the estimated value is equal to or smaller than the first value and is greater than a second value, and to set zero as the subtraction amount when the estimated value is smaller than the second value.

In this manner, in a case where the estimated value of the full charge capacity is greater than the first value, the full charge capacity of the battery can be accurately displayed by setting the first SOC range corresponding to the dead band as the subtraction amount.

In another embodiment, the control device is configured to calculate the subtraction amount by using, in addition to the first SOC range, an SOC range that decreases due to swelling of the single cells.

In this manner, the full charge capacity of the battery can be further accurately displayed on the display device.

According to the present disclosure, a display system that accurately displays a capacity of a battery can be provided.

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
FIG. 1 is a diagram showing an example of an overall configuration of an electrified vehicle equipped with a display system according to the present embodiment;
FIG. 2 is a diagram showing a relationship between an OCV and a residual capacity in a single cell of the present embodiment;
FIG. 3 is a flowchart showing an example of a process that is executed by an ECU;
FIG. 4 is a diagram for describing a relationship between a detection error and a dead band SOC range; and
FIG. 5 is a diagram showing an example of a relationship between the estimated value of the full charge capacity and the subtraction amount ΔC(0).

### DETAILED DESCRIPTION OF EMBODIMENTS

In the following, an embodiment of the present disclosure will be described in detail with reference to the drawings. It should be noted that, in the drawings, the same or corresponding parts are designated by the same reference signs and the description thereof will not be repeated.

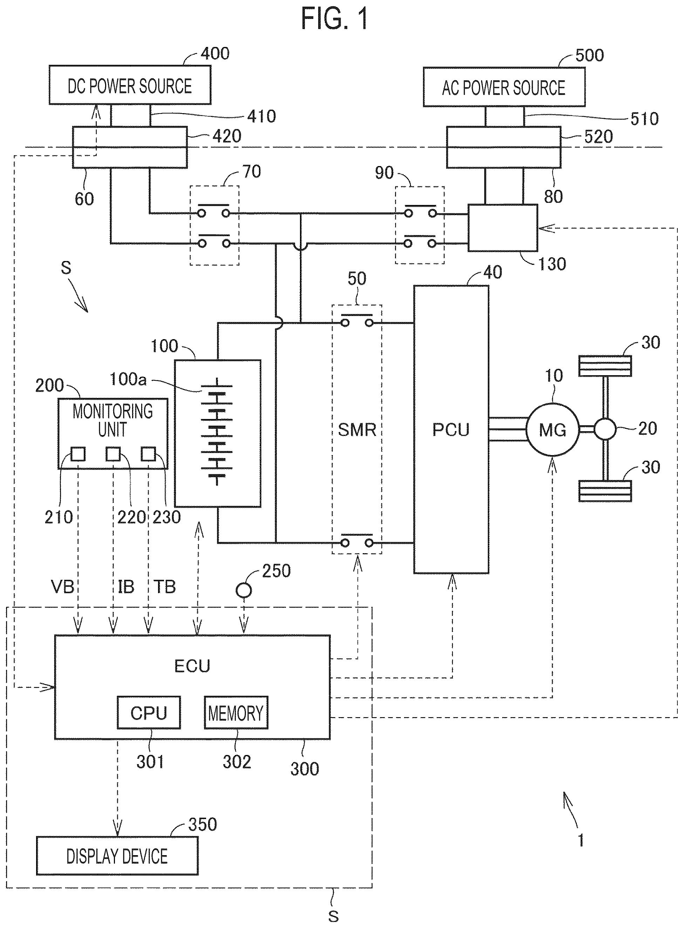

Hereinafter, an example of a display system S according to the present embodiment will be described. FIG. 1 is a diagram showing an example of an overall configuration of an electrified vehicle 1 equipped with the display system S according to the present embodiment. In the present embodiment, the electrified vehicle 1 is, for example, a battery electric vehicle. The electrified vehicle 1 includes a motor generator (MG) 10 that is a rotating electric machine, a power transmission gear 20, drive wheels 30, a power control unit (PCU) 40, a system main relay (SMR) 50, a battery 100, a monitoring unit 200, an electronic control unit (ECU) 300 that is an example of a control device, and a display device 350. The display system S is configured by the ECU 300 and the display device 350.

The MG 10 is, for example, an interior permanent magnet synchronous motor (IPM motor) having both a function as a motor and a function as a generator. An output torque of the MG 10 is transmitted to the drive wheels 30 via the power transmission gear 20 configured to include a reduction gear, a differential device, and the like.

During braking of the electrified vehicle 1, the MG 10 is driven by the drive wheels 30, and the MG 10 operates as a generator. As a result, the MG 10 also functions as a braking device that performs regenerative braking of converting the kinetic energy of the electrified vehicle 1 into electric power. The regenerated electric power generated by the regenerative braking force in the MG 10 is stored in the battery 100.

The PCU 40 is a power conversion device that bidirectionally converts electric power between the MG 10 and the battery 100. The PCU 40 includes, for example, an inverter and a converter (both not shown) that operate based on a control signal from the ECU 300.

When the battery 100 discharges, the converter boosts the voltage supplied from the battery 100 and supplies the boosted voltage to the inverter. The inverter converts the direct current power supplied from the converter into alternating current power to drive the MG 10.

When the battery 100 is charged, the inverter converts the alternating current power generated by the MG 10 into direct current power and supplies the direct current power to the converter. The converter steps down the voltage supplied from the inverter to a voltage suitable for charging the battery 100 and supplies the stepped-down voltage to the battery 100.

The SMR 50 is electrically connected to a power line connecting the battery 100 and the PCU 40. In a case where the SMR 50 is closed (ON) in response to the control signal from the ECU 300, electric power can be exchanged between the battery 100 and the PCU 40. On the other hand, in a case where the SMR 50 is opened (OFF) in response to the control signal from the ECU 300, the electrical connection between the battery 100 and the PCU 40 is cut off.

The battery 100 stores electric power for driving the MG 10. The battery 100 is a rechargeable direct current power source (secondary battery), and is configured by laminating a plurality of single cells (battery cells) 100a, for example, electrically connected in series. The single cell 100a may be configured by, for example, a lithium ion battery. In the present embodiment, the single cell 100a is a lithium iron phosphate ion battery (LFP battery) using lithium iron phosphate as a positive electrode active material.

The monitoring unit 200 includes a voltage sensor 210, a current sensor 220, and a temperature sensor 230. The voltage sensor 210 detects a voltage VB of the single cell 100a (voltage VB between terminals of each of the single cells 100a). The current sensor 220 detects a current IB input to and output from the battery 100 (single cell 100a). The current IB may be positive (+) in a case of charging the battery 100 and negative (-) in a case of being discharged from the battery 100. The temperature sensor 230 detects a temperature TB of each of the single cells 100a. The monitoring unit 200 outputs a detection result of each of the detection units to the ECU 300.

The electrified vehicle 1 includes a DC inlet 60, and the battery 100 can be rapidly charged from an external direct current (DC) power source that is a charging facility. The DC inlet 60 is configured such that a connector 420 provided at a distal end of a charging cable 410 of an external DC power source (charging facility) 400 is connectable to the DC inlet 60. A charging relay 70 is electrically connected to a power line connecting the DC inlet 60 and the battery 100. The charging relay 70 switches between supply and cutoff of electric power between the DC inlet 60 and the battery 100 in response to the control signal from the ECU 300. In a case where the charging relay 70 is closed, the external charging (rapid charging) of the battery 100 is executed.

The electrified vehicle 1 includes an AC inlet 80, and the battery 100 can be charged at a normal rate from an external alternating current (AC) power source that is a charging facility. The AC inlet 80 is configured such that a connector 520 provided at a distal end of a charging cable 510 of an external AC power source (charging facility) 500 is connectable to the AC inlet 80. An on-board charger 130 is provided in a power line between the AC inlet 80 and the battery 100, and converts alternating current power supplied from an external AC power source into direct current power and converts the direct current power into a voltage that can charge the battery 100. A charging relay 90 is electrically connected to a power line connecting the on-board charger 130 and the battery 100. The charging relay 90 switches between supply and cutoff of electric power between the on-board charger 130 and the battery 100 in response to the control signal from the ECU 300. In a case where the charging relay 90 is closed, the external charging (normal charging) of the battery 100 is executed.

The ECU 300 includes a central processing unit (CPU) 301 and a memory (including, for example, a read only memory (ROM), a random access memory (RAM), or the like) 302. The ECU 300 controls each device such that the electrified vehicle 1 is in a desired state based on a signal received from the monitoring unit 200, a signal (for example, an accelerator operation amount signal, a vehicle speed signal, or the like) from various sensors (not shown), and information such as a map and a program stored in the memory 302. In addition, the ECU 300 executes a process of estimating the full charge capacity etc.

The display device 350 is configured to display character information as a visual message to a user of the electrified vehicle 1 in response to a control command from the ECU 300. The display device 350 is configured by, for example, a display unit of a touch panel display provided around a driver's seat. The display unit is configured by, for example, a liquid crystal display (LCD), organic electro-luminescence (EL), or the like. The display device 350 may be provided in, for example, a combination meter (not shown) that is visible to the user of the electrified vehicle 1 when the user is seated in the driver's seat.

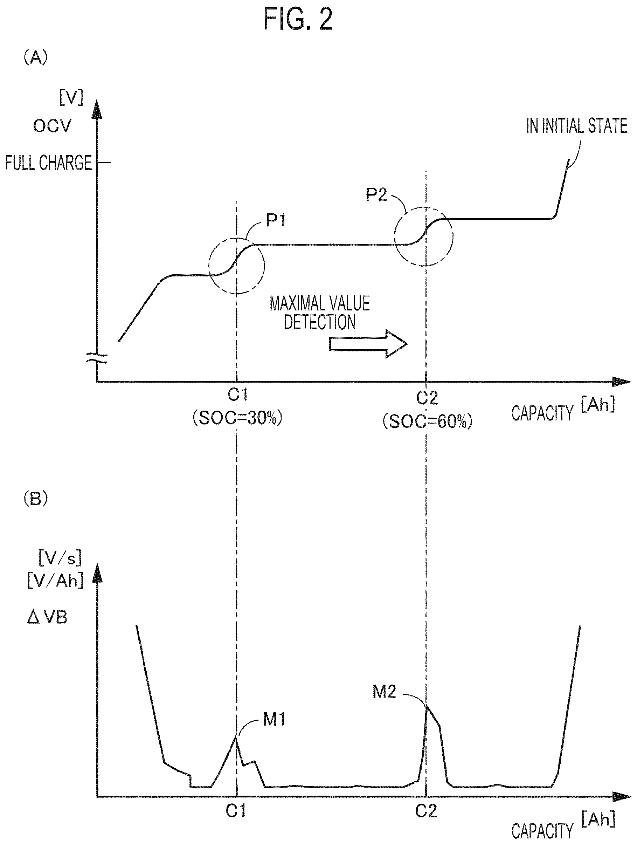

FIG. 2 is a diagram showing a relationship between an open circuit voltage (OCV) and a residual capacity in the single cell 100a (LFP battery) of the present embodiment. In a part (A) of FIG. 2, a vertical axis is an OCV (V) of the single cell 100a, and a horizontal axis is a residual capacity (charge capacity) (Ah) of the single cell 100a. As shown in the part (A) of FIG. 2, a relationship between the OCV and the residual capacity (hereinafter, this relationship is also referred to as an OCV curve) has a wide region (voltage flat region) in which a change in the OCV curve is small. In a case where a portion where the OCV curve increases from the voltage flat region and then transitions into another voltage flat region is referred to as a "step", two steps P1, P2 are present in the single cell 100a of the present embodiment.

In a single cell 100a in an initial state, the first step P1 (on the lower-voltage side of the OCV) appears at an SOC of around 30%, and the second step P2 (on the higher-voltage side of the OCV) appears at an SOC of around 60%.

A part (B) of FIG. 2 shows a relationship between a voltage change amount ΔVB of the voltage VB during charging of the battery 100 and the residual capacity, and shows a relationship in a case of charging or discharging at a constant current. The voltage change amount ΔVB is a change amount (V/Ah) of the voltage VB with respect to the residual capacity (charge capacity) or a change amount (V/s) of the voltage VB with respect to time (charging time or discharging time). As shown in the part (B) of FIG. 2, the voltage change amount ΔVB is a maximal value M1 in the residual capacity corresponding to the step P1 and is a maximal value M2 in the residual capacity corresponding to the step P2. Therefore, the residual capacity in which the voltage change amount ΔVB is the maximal value M2 is stored as a reference capacity C2, a charging current from the voltage change amount ΔVB being the maximal value M2 to full charge is integrated, and by adding the integrated value to the reference capacity C2, the full charge capacity of the battery 100 (single cell 100a) can be estimated.

Since the battery 100 described above is configured by a plurality of single cells 100a, the SOC may vary between the single cells 100a. In such a case, a balancing process of bringing each of the single cells 100a constituting the battery 100 into the full charge state to eliminate the variation in the SOC is executed. However, when the state in which the balancing process is not executed continues, the variation in the SOC between the single cells expands, the entire capacity of the battery 100 cannot be used, and a deviation may occur between an actual value and the estimated value of the distance travelable by electric power. Therefore, there is a possibility that the current capacity or the full charge capacity of the battery 100 cannot be accurately displayed.

Therefore, in the present embodiment, the ECU 300 calculates the subtraction amount ΔC(0) by using a first SOC range corresponding to the dead band based on the SOC set as the full charge state, subtracts the subtraction amount from a second SOC range in which the battery is usable, and causes the information related to the full charge capacity to be displayed on the display device 350 by using a ratio of a value obtained by subtracting the subtraction amount from the second SOC range to the second SOC range.

In this manner, the full charge capacity of the battery 100 can be accurately displayed.

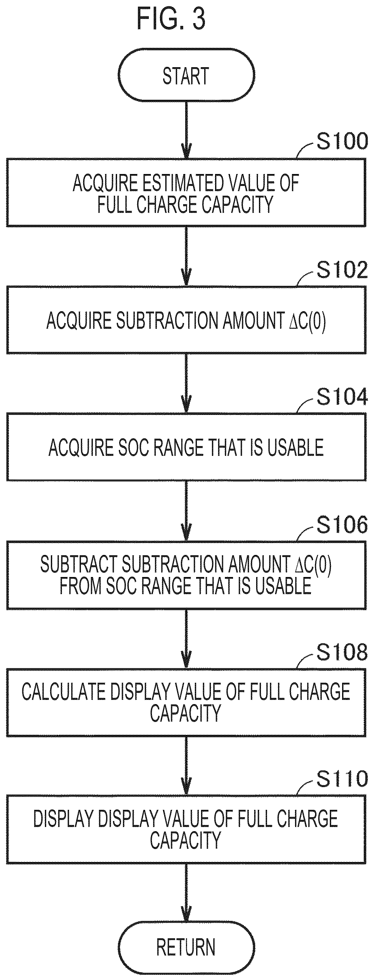

Hereinafter, an example of a process executed by the ECU 300 will be described with reference to FIG. 3. FIG. 3 is a flowchart showing an example of a process that is executed by the ECU 300. For example, in a case where the connector 420 is connected to the DC inlet 60 or the connector 520 is connected to the AC inlet 80, the external charging of the battery 100 is started. In a case where the external charging of the battery 100 is started, the process shown in the flowchart is executed.

In step (hereinafter, the step is referred to as S) 100, the ECU 300 acquires the estimated value of the full charge capacity. The ECU 300 acquires the estimated value of the full charge capacity from, for example, the monitoring unit 200. The monitoring unit 200 calculates the estimated value of the full charge capacity from, for example, an OCV (1) at a start of charging of the battery 100 in the most recent charging, an OCV (2) at an end of the charging, and an integrated value of a charging current from the start of the charging to the end of the charging. The monitoring unit 200 calculates the estimated value of the full charge capacity from, for example, a change amount ΔSOC of the SOC calculated from a difference between the OCV (1) and the OCV (2) and a change amount of the capacity due to the integrated value of the charging current. The estimated value of the full charge capacity may be calculated by the ECU 300. Thereafter, the process proceeds to S102.

In S102, the ECU 300 acquires the subtraction amount ΔC(0). More specifically, the ECU 300 calculates the variation amount of the capacity (that is, the subtraction amount ΔC(0)) by using the SOC width corresponding to the dead band based on the SOC set as the full charge state. For example, the SOC corresponding to the dead band in a case where the state in which the SOC is 95% is set in advance as the full charge state is calculated in advance. The SOC width corresponding to the dead band indicates the SOC width corresponding to the voltage range configured by the detection error of the voltage sensor 210, and is calibrated by experiment or the like.

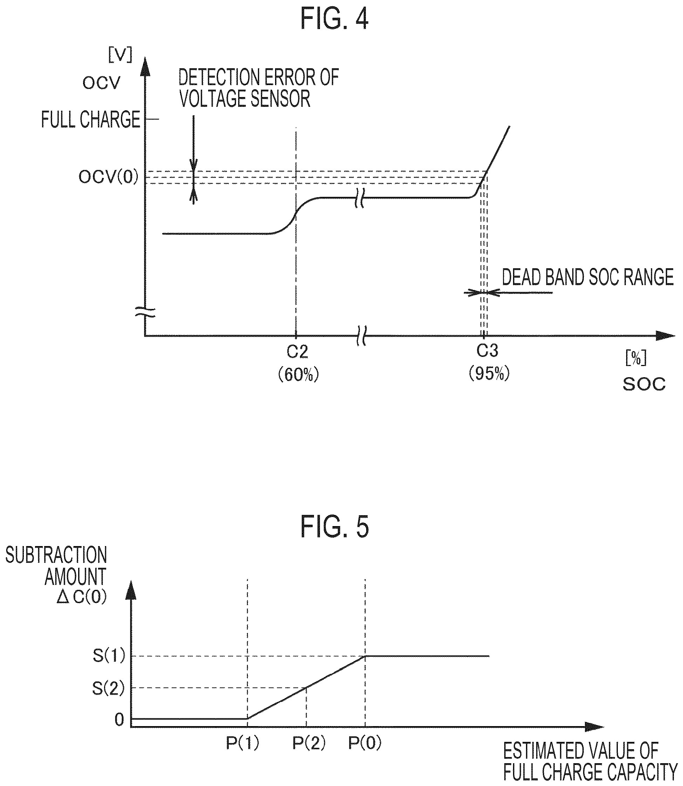

FIG. 4 is a diagram for describing a relationship between the detection error and the dead band SOC range. A vertical axis of FIG. 4 indicates the OCV. A horizontal axis of FIG. 4 indicates the SOC. FIG. 4 shows an example of a change in the OCV with respect to the change in the SOC of the single cell 100a. C2 in FIG. 4 is the SOC corresponding to the step P2 described above, and is, for example, 60%. Since the step P2 is as described above, the detailed description thereof will not be repeated. C3 in FIG. 4 is the SOC set as the full charge state, and is, for example, 95%. As shown in FIG. 4, in a case where the state in which the SOC is 95% is set as the full charge state, when the OCV corresponding to the SOC of 95% (C3 in FIG. 4) is set to OCV (0), the detection error of the voltage sensor 210 that detects the OCV is indicated by a voltage range defined by an error amount in a positive direction and an error amount in a negative direction based on the OCV (0). The range of the SOC corresponding to the voltage range is set as the SOC range (corresponding to the first SOC range) of the dead band. In the following description, the size of the first SOC range of the dead band is S(1).

For example, the memory 302 of the ECU 300 stores a map indicating a relationship between the preset estimated value of the full charge capacity and the subtraction amount. The ECU 300 calculates the subtraction amount ΔC(0) by using the acquired estimated value of the full charge capacity and the map.

FIG. 5 is a diagram showing an example of a relationship between the estimated value of the full charge capacity and the subtraction amount ΔC(0). A vertical axis of FIG. 5 indicates the subtraction amount ΔC(0). A horizontal axis of FIG. 5 indicates the estimated value of the full charge capacity. As shown in FIG. 5, the relationship between the estimated value of the full charge capacity and the subtraction amount ΔC(0) shows the following relationship. That is, when the estimated value of the full charge capacity is greater than P(0), S(1) is set as the subtraction amount ΔC(0). Further, when the estimated value of the full charge capacity is equal to or smaller than P(0) and is equal to or greater than P(1), the subtraction amount ΔC(0) is set to decrease in proportion to the decrease in the estimated value from S(1). For example, when the estimated value is P(0) or less and is P(2) that is equal to or greater than P(1), the ECU 300 sets S(2) as the subtraction amount ΔC(0) from the map. Further, in a case where the estimated value of the full charge capacity is smaller than P(1), zero is set as the subtraction amount ΔC(0).

The ECU 300 sets the subtraction amount ΔC(0) from the acquired estimated value of the full charge capacity and the map shown in FIG. 5. Thereafter, the process proceeds to S104.

In S104, the ECU 300 acquires the SOC range that is usable (corresponding to the second SOC range). The SOC range that is usable is, for example, an SOC range calculated by subtracting the SOC at which the traveling of the electrified vehicle 1 is ended from the SOC (95%) corresponding to the full charge state. The SOC at which the traveling of the electrified vehicle 1 is ended is a predetermined value. The SOC range that is usable is a predetermined value, and may be stored in the memory 302 of the ECU 300, may be acquired from a storage device (not shown) of the monitoring unit 200, or may be acquired from an external server. Thereafter, the process proceeds to S106.

In S106, the ECU 300 subtracts the subtraction amount ΔC(0) from the SOC range that is usable. Thereafter, the process proceeds to S108.

In S108, the ECU 300 calculates the display value of the full charge capacity. Specifically, the ECU 300 calculates a ratio of a value obtained by subtracting the subtraction amount ΔC(0) from the second SOC range to the second SOC range. That is, the ECU 300 calculates the value of the ratio by dividing the value obtained by subtracting the subtraction amount ΔC(0) from the SOC range that is usable by the SOC range that is usable. The ECU 300 calculates the display value of the full charge capacity (corrected value of capacity retention rate) by multiplying the current capacity retention rate value by the calculated value of the ratio. The ECU 300 calculates the current capacity retention rate value by dividing the estimated value of the full charge capacity by the initial value of the full charge capacity, for example. The initial value of the full charge capacity is the full charge capacity when no battery deterioration has occurred. The initial value of the full charge capacity is, for example, a predetermined value depending on the type of the battery 100, and may be stored in the memory 302 of the ECU 300, may be acquired from a storage device (not shown) of the monitoring unit 200, or may be acquired from an external server. Thereafter, the process proceeds to S110.

In S110, the ECU 300 causes the calculated display value of the full charge capacity to be displayed on the display device 350. Thereafter, the process ends.

The operation of the ECU 300 based on the structure and the flowchart as described above will be described. For example, in a case where the connector 420 is connected to the DC inlet 60, the external charging of the battery 100 is started.

In a case where the external charging of the battery 100 is started, the ECU 300 acquires the estimated value of the full charge capacity from the monitoring unit 200 (S100). Then, the subtraction amount ΔC(0) is acquired using the acquired estimated value of the full charge capacity and the map shown in FIG. 5 (S102). For example, in a case where the estimated value of the full charge capacity is greater than P(0), S(1) is acquired as the subtraction amount ΔC(0) from the map shown in FIG. 5. Thereafter, the ECU 300 acquires the SOC range in which the battery 100 is usable from the memory 302 (S104), and subtracts the subtraction amount ΔC(0) from the SOC range that is usable (S106). The display value of the full charge capacity is calculated by multiplying the ratio of the value obtained by subtracting the subtraction amount ΔC(0) from the SOC range that is usable to the SOC range that is usable by the current capacity retention rate (S108), and the information indicating the calculated display value is displayed on the display device 350 (S110).

As described above, with the display system S according to the present embodiment, the display value of the full charge capacity is calculated by using the ratio of the value obtained by subtracting the subtraction amount ΔC(0) from the SOC range that is usable to the SOC range that is usable, and the calculated display value is displayed on the display device 350, whereby the full charge capacity of the battery 100 can be accurately displayed. Therefore, a display system that accurately displays the capacity of the battery can be provided.

Further, the ECU 300 sets S(1) as the subtraction amount ΔC(0) when the estimated value of the full charge capacity is greater than P(0). In addition, the ECU 300 sets a value that decreases in proportion to the decrease in the estimated value as the subtraction amount ΔC(0) when the estimated value of the full charge capacity is equal to or smaller than P(0) and is equal to or greater than P(1). Further, the ECU 300 sets zero as the subtraction amount ΔC(0) when the estimated value of the full charge capacity is smaller than P(1). In this manner, in a case where the estimated value of the full charge capacity is greater than P(0), the full charge capacity of the battery 100 can be accurately displayed by setting the SOC range corresponding to the dead band as the subtraction amount ΔC(0).

Hereinafter, modifications will be described.
In the embodiment described above, the SOC range corresponding to the dead band is set as the subtraction amount ΔC(0), and the ratio of the SOC range that is usable is calculated by subtracting the subtraction amount ΔC(0) from the SOC range that is usable, but the present disclosure is not particularly limited to such correction. The ECU 300 may subtract, for example, the SOC range that is reduced due to the swelling of the battery 100 in addition to the subtraction amount ΔC(0) from the SOC range that is usable. The SOC range that is reduced due to the swelling may be, for example, a predetermined value or may be set in accordance with the deterioration state of the single cell 100a. In this manner, the full charge capacity of the battery 100 can be further accurately displayed.

Further, in the embodiment described above, the subtraction amount ΔC(0) is described to be calculated by using the estimated value of the full charge capacity and the map shown in FIG. 5, but the map used to calculate the subtraction amount ΔC(0) is not particularly limited to the map shown in FIG. 5. For example, the map shown in FIG. 5 may be set such that, between an upper limit value and a lower limit value of the estimated value, the subtraction amount ΔC(0) monotonically decreases linearly or nonlinearly (the subtraction amount ΔC(0) decreases as the estimated value decreases). Alternatively, the size of the SOC range corresponding to the dead band may be set as the subtraction amount ΔC(0) regardless of the change in the estimated value.

Further, in the embodiment described above, although the SOC range corresponding to the voltage range indicating the detection error of the voltage sensor 210 is described as being set as the SOC range of the dead band, the SOC range may be set as the SOC range of the dead band by adding a certain margin to an upper limit or a lower limit of the SOC range corresponding to the voltage range indicating the detection error.

Further, in the embodiment described above, the case where the state in which the SOC is 95% is set as the full charge state is described as an example, but the SOC corresponding to the full charge state is not limited to 95%.

It should be noted that the modifications described above may be carried out by combining all or a part thereof as appropriate.
The embodiments disclosed herein should be considered as illustrative and not restrictive in all respects. The scope of the present invention is shown by the scope of claims, rather than the description above, and is intended to include all modifications within the meaning and the scope equivalent to the scope of claims.

## Claims

1. A display system that displays information related to a full charge capacity of a battery including a plurality of single cells of a lithium iron phosphate ion battery, the display system comprising:
a display device; and
a control device, wherein:
the control device is configured to calculate a subtraction amount using a first state-of-charge range corresponding to a dead band that is based on a state of charge set as a full charge state, and to subtract the subtraction amount from a second state-of-charge range in which the battery is usable; and
the display device is configured to display the information related to the full charge capacity by using a ratio of a value obtained by subtracting the subtraction amount from the second state-of-charge range to the second state-of-charge range.

2. The display system according to claim 1, wherein the control device is configured to set the subtraction amount corresponding to the first state-of-charge range when an estimated value of the full charge capacity is greater than a first value, to set a value that decreases in proportion to a decrease in the estimated value as the subtraction amount when the estimated value is equal to or smaller than the first value and is greater than a second value, and to set zero as the subtraction amount when the estimated value is smaller than the second value.

3. The display system according to claim 1 or 2, wherein the control device is configured to calculate the subtraction amount by using, in addition to the first state-of-charge range, a state-of-charge range that decreases due to swelling of the single cells.
